# EUROPEAN PATENT SPECIFICATION

(11) **EP 0 519 631 B1**
(45) Date of publication and mention of the grant of the patent: **15.04.1998**
(21) Application number: 92305243.5
(22) Date of filing: 08.06.1992
(51) Int. Cl.: H05K 3/46, H05K 3/28, H05K 3/02

(54) **Both-side roughened copper foil with protection film**
Beidseitig aufgerauhte Kupferfolie mit Schutzfilm
Feuille en cuivre rugueuse des deux côtés avec pellicule protectrice

(30) Priority: 18.06.1991 JP 145704/91
(43) Date of publication of application: 23.12.1992
(73) Proprietor: SUMITOMO BAKELITE COMPANY LIMITED, Tokyo 100 (JP); CIRCUIT FOIL JAPAN CO. LTD, Chiyoda-ku, Tokyo (JP)
(72) Inventor: Keiji, Azuma, c/o Sumitomo Bakelite, Chiyoda-ku, Tokyo (JP); Kimikazu, Katoh, c/o Sumitomo Bakelite, Chiyoda-ku, Tokyo (JP); Ryoichi, Oguro, c/o Circuit Foil Japan, Nishiki-cho, Chiyoda-ku, Tokyo (JP)
(74) Representative: Simpson, Alison Elizabeth Fraser

(56) References cited:
- EP-A- 0 395 871
- DE-A- 1 778 825

## Description

The present invention relates to a copper foil with both sides roughened, which has a polyamide-type protection film, e.g. for use in an inner layer circuit of a multi-layered printed circuit board.

Methods of producing a copper-clad laminated board (hereinafter abbreviated as "CCLB") for a multi-layered printed circuit board (hereinafter abbreviated as "MLPCB") include press molding of a both-side roughened copper foil (hereinafter abbreviated as "BSRCF") placed on a single prepreg therewith, and press molding of BSRCFs placed on both sides of a lamination of multiple prepregs therewith. The roughening of a copper foil is performed to improve the bonding between the copper foil and the prepreg.

However a BSRCF has such a shortcoming that when it is pressed with a prepreg, fine ruggedness on the roughened surface of the copper foil, which is pressed with a press plate, are likely to be crushed.

To prevent the crushing of ruggedness on the surface of the BSRCF, a metal film such as a copper foil or aluminum foil, or a conventionally used organic film such as polypropylene, polyethylene terephthalate, polyethylene, triphenylpentene or Tedra (trade name of a resin film made by Du Pont) is placed between a press plate and a BSRCF at the time of press molding (see e.g. EP-A-0 395 871 and DE-A-1 778 825).

It is however a very troublesome work to laminate the mentioned metal film or organic film on the BSRCF before pressing them in a press molding step. In addition, when the above mentioned organic film is used, the property of separation from the press plate is bad, and when the film is separated from the BSRCF after the press molding, printing of the organic film on the surface of the copper foil would be seen on the electron microscopic level. This printing will have bad effect upon the subsequent process.

Conventionally, BSRCFs are supplied in a roll or sheet form, so that the ruggedness on the roughened surface may be smashed or foreign matter may stick on the roughened surface, for example, when the BSRCF is cut, packed or transported.

### SUMMARY OF THE INVENTION

It is the object of the present invention to provide a BSRCF with a protection film, which can protect the ruggedness on the roughened surface at the time the BSRCF is cut, packed, transported or stacked on another BSRCF, can simplify the press molding work, and can improve the production efficiency particularly in the step of fabricating a CCLB for a printed circuit board as well as the quality of the acquired CCLB.

According to this invention, there is provided a both-sides roughened copper foil having a protection film for press moulding onto a prepreg or multiple prepregs characterised in that the protection film comprises a polyamide-type film having a melting point equal to or higher than the lamination temperature used during press moulding, said film being bonded on one side of the both sides roughened copper foil continuously or discontinuously at one edge or both edges thereof.

### DESCRIPTION OF THE PREFERRED EMBODIMENTS

The present invention will be described in detail below.

Available as a BSRCF, which is used in the present invention, are those acquired by subjecting an electrodeposited copper foil or a rolled copper foil to cathode processing in a copper sulfate bath of a sulfuric acid to thereby have coarse particles stuck on its surfaces (see Japanese Patent Publication Nos. 38053/79 and 39327/78), and subjecting the same to anode processing in an acidic bath for etching both surfaces of the copper foil so that the copper foil has roughened surfaces (see Japanese Patent Publication No. 54592/86).

The ruggedness on those BSRCFs are minute projections whose size is an Rz value specified in JIS B 0601. The Rz value is, for example, 2 to 8 µm for an electrodeposited copper foil or rolled copper foil having its lustrous surface subjected to cathode processing, about 0.4 µm for the same foil having its lustrous surface etched to have a roughened surface, 6 to 15 µm for an electrodeposited copper foil having its lusterless surface subjected to cathode processing, and 4 to 8 µm for the same foil having its lusterless surface etched to have a roughened surface.

The metal foil for use in this invention is preferably an electrodeposited copper foil, a rolled copper foil or an aluminum foil, and the thickness of this foil, though not particularly restricted, is preferably between 18 µm to 70 µm.

An organic film to be used in this invention is not particularly restricted as long as its melting point is equal to or higher than the lamination temperature. Since the press molding is generally done at a heated temperature of 170 °C or higher, under pressure of 10 kgf/cm² or higher and for 60 minutes or longer, it is preferable to use an organic film having a melting point of 170°C or higher in order to prevent part of the film from sticking on the ruggedness of the BSRCF or being fused on the press plate. A preferable organic film is a polyamide-type resin film having a melting point of 170 °C or higher; nylon 6 expressed by a chemical formula of (-NH(CH₂)₅CO-)ₙ and nylon 66 expressed by a chemical formula of (-NH(CH₂)₆NHCO(CH₂)₄CO-)ₙ are more preferable. The measurement of the melting point of polyamide is conducted by ASTMD 2117-64.

The thickness of the organic film, though not particularly restricted, is preferably between 10 µm to 100 µm for easier handling.

A BSRCF with a protection film according to the present invention can be acquired by continuously or continually bonding the metal foil or organic film to the copper foil at one edge or both edges thereof by means of bond or adhesive. When the protection film is bonded to the whole surface of the BSRCF by bond or adhesive, the bond or adhesive not only remains on the ruggedness of the surface of the BSRCF after the protection film is separated therefrom, but also the stuck bond or adhesive undesirably fill dents of the ruggedness.

The bond or adhesive to be used in this invention may be a cyanoacrylate-type instantaneous adhesive agent, anaerobic adhesive, epoxy-type adhesive or pressure sensitive adhesive double coated tape. The bonding or adhering width using such adhesive, though not particularly restricted, is preferably 5 to 15 mm.

### Examples

Embodiments of the present invention will be more specifically described below.

### Example 1

While slitting a BSRCF (35 µm in thickness, a product of Circuit Foil Japan Co., Ltd.) to 1100 mm in width, an electrodeposited copper foil (protection film), 18 µm in thickness, was placed over the lustrous side of the BSRCF [Rz value: 5.5 µm (cathode processing)], was continuously adhered thereto 10 mm wide at both edges thereof by means of anaerobic adhesive, and rolled to yield a BSRCF with a protection film.

After the acquired BSRCF with a protection film was cut into sheets, a lamination of four glass epoxy prepregs, EI-6765 [(resin content of 45 %), 180 µm in thickness; a product of Sumitomo Bakelite Co., Ltd.], was placed on that roughened surface having no protection film thereon, and the top and bottom of the resultant structure were held by press plates and heated and press-molded at a temperature of 170°C for 180 minutes.

Then, the press plates were removed, and evaluation was made on the following items. The results of the evaluation are shown in Table 1.

Easiness of peeling of protection film from roughened surface:
○ represents easy separation of the protection film from the BSRCF without separation resistance.

Shape of ruggedness on roughened surface:
The shape of the ruggedness on the roughened surface without the protection film was observed with an electron microscope (magnification: x 2000).

Remainder on roughened surface:
After the protection film was separated, the presence or absence of any remainder on the roughened surface was checked with an electron microscope (magnification: x 2000).

### Example 2

A BSRCF with a protection film was produced in the same manner as Example 1 except that a rolled copper foil with a thickness of 35 µm was used as the protection film in place of the electrodeposited copper foil, and evaluation was made on the easiness of peeling of the protection film from the roughened surface, the shapes of the ruggedness on the roughened surface, and the remainder thereon. The results of the evaluation is presented in Table 1.

### Example 3

A BSRCF with a protection film was produced in the same manner as Example 1 except for the replacement of the electrodeposited copper foil with a rolled aluminum foil, 40 µm in thickness, as the protection film, and evaluation was made on the easiness of peeling of the protection film from the roughened surface, the shapes of the ruggedness on the roughened surface, and the remainder thereon. The results of the evaluation is presented in Table 1.

### Example 4

A BSRCF with a protection film was produced in the same manner as Example 1 except for the replacement of the electrodeposited copper foil with a film of nylon 6 (melting point: 220 °C), 20 µm in thickness, as the protection film, and evaluation was made on the easiness of peeling of the protection film from the roughened surface, the shapes of the ruggedness on the roughened surface, and the remainder thereon. The results of the evaluation is presented in Table 1.

### Example 5

A BSRCF with a protection film was produced in the same manner as Example 1 except for the replacement of the electrodeposited copper foil with a film of nylon 66 (melting point: 230 °C), 25 µm in thickness, as the protection film, and evaluation was made on the easiness of peeling of the protection film from the roughened surface, the shapes of the ruggedness on the roughened surface, and the remainder thereon. The results of the evaluation is presented in Table 1.

### Comparative Example 1

Prepregs were placed over a BSRCF without a protection film and the resultant structure was heated and press-molded in the same manner as Example 1, and evaluation was made on the easiness of peeling of the protection film from the roughened surface, the shapes of the ruggedness on the roughened surface, and the remainder thereon. The results of the evaluation is presented in Table 1.

**Table 1**

| | Material for Protection Film | Easiness of Peeling | Shape of Ruggedness on Copper Foil | Remainder on Copper Foil |
|---|---|---|---|---|
| Example 1 | Electrodeposited copper foil | ○ | No change | none |
| Example 2 | Rolled copper foil | ○ | No change | none |
| Example 3 | Aluminum foil | ○ | No change | Slight |
| Example 4 | Nylon 6 | ○ | No change | None |
| Example 5 | Nylon 66 | ○ | No change | None |
| Comparative Example 1 | none | - | Rupture occurred | None |

The BSRCF with a protection film according to the present invention have the following advantages.
(1) Since the BSRCF is provided with a protection film, it is possible to prevent the ruggedness on the roughened surface from being smashed, or foreign matter from being stuck on the roughened surface when the BSRCF is cut, packed or transported, or when the copper foil is press-molded with a prepreg or the like.
(2) Because a separate protection film need not be used at the time of press molding, the press molding work can be simplified.
(3) When the protection film is separated from the BSRCF after press molding, no residual fragments of the protection film will stick on the roughened surface.
(4) The protection film is bonded or adhered to the copper foil only at one edge or both edges, so that remainder of bond or adhesive hardly stick on the roughened surface.
(5) Therefore, it is possible to improve the production efficiency particularly in the step of fabricating a CCLB for a printed circuit board and improve the quality of the acquired CCLB for a printed circuit board.

## Claims

1. A both-sides roughened copper foil having a protection film for press moulding onto a prepreg or multiple prepregs characterised in that the protection film comprises a polyamide-type film having a melting point equal to or higher than the lamination temperature used during press moulding, said film being bonded on one side of the both sides roughened copper foil continuously or discontinuously at one edge or both edges thereof.

2. A both-sides roughened copper foil according to claim 1, wherein the polyamide-type film has a melting point of 170°C or higher.

3. A both-side roughened copper foil according to claims 1 or 2 wherein the polyamide-type film is selected from nylon 6, and nylon 66.

## Patentansprüche

1. Beidseitig aufgerauhte Kupferfolie mit einem Schutzfilm für ein Preßformen auf ein Prepreg oder mehrere Prepregs, dadurch gekennzeichnet, daß der Schutzfilm aus einem Film des Polyamid-Typs mit einem Schmelzpunkt gleich oder höher als die Laminierungstemperatur besteht, die während des Preßformens benutzt wird, wobei der Film an einer Seite der beidseitig aufgerauhten Kupferfolie kontinuierlich oder diskontinuierlich an deren einer Kante oder an beiden Kanten angeklebt ist.

2. Beidseitig aufgerauhte Kupferfolie nach Anspruch 1, bei welcher der Film des Polyamid-Typs einen Schmelzpunkt von 170°C oder höher hat.

3. Beidseitig aufgerauhte Kupferfolie nach Anspruch 1 oder 2, bei welcher der Film des Polyamid-Typs aus Nylon 6 oder Nylon 66 ausgewählt ist.

## Revendications

1. Feuille en cuivre rugueuse des deux côtés, ayant une pellicule protectrice pour moulage sous presse sur une feuille préimprégnée ou sur des feuilles préimprégnées multiples, caractérisée en ce que la pellicule protectrice comprend une pellicule du type polyamide ayant un point de fusion égal ou supérieur à la température de lamination utilisée pendant le moulage sous presse, ladite pellicule étant liée, sur un côté de la feuille en cuivre rugueuse des deux côtés, d'une manière continue ou d'une manière discontinue, à un bord ou à deux bords de celle-ci.

2. Feuille en cuivre rugueuse des deux côtés selon la revendication 1, caractérisée en ce que la pellicule du type polyamide a un point de fusion de 170°C ou plus.

3. Feuille en cuivre rugueuse des deux côtés selon la revendication 1 ou 2, caractérisée en ce que la pellicule du type polyamide est choisie parmi le nylon 6 et le nylon 66.
